# EUROPÄISCHE PATENTSCHRIFT

(11) **EP 0 865 617 B1**
(45) Veröffentlichungstag und Bekanntmachung des Hinweises auf die Patenterteilung: **24.10.2001**
(21) Anmeldenummer: 96943051.1
(22) Anmeldetag: 06.12.1996
(51) Int. Cl.: G02B 5/30

(54) **POLARISATOR AUS BREWSTERPLATTEN**
POLARISER MADE FROM BREWSTER PLATES
POLARISEUR CONSTITUE DE LAMES DE BREWSTER

(30) Priorität: 08.12.1995 DE 19545821
(43) Veröffentlichungstag der Anmeldung: 23.09.1998
(73) Patentinhaber: Lüllau, Friedrich, 21357 Bardowick (DE)
(72) Erfinder: LÜLLAU , Friedrich, D-21357 Bardowick (DE); MAYER, Claus, D-21379 Scharnebeck (DE)
(74) Vertreter: Vonnemann, Gerhard, Dr.-Ing.
(86) Internationale Anmeldenummer: EP9605473
(87) Internationale Veröffentlichungsnummer: WO9722021

(56) Entgegenhaltungen:
- WO-A-95/18394
- WO-A-95/22787
- FR-A- 2 654 844
- US-A- 3 439 968
- US-A- 5 384 659

## Beschreibung

Die Erfindung betrifft eine Polarisatoranordnung gemäß dem Oberbegriff des Patentanspruchs 1. Außerdem betrifft die Erfindung einen Projektionsapparat und eine Vorrichtung zur photomechanischen Herstellung strukturierter Oberflächen.

Als Polarisatoren für große Aperturen kommen üblicherweise dicroitische Folien, Strahlteilerwürfel mit dielektrischen Schichten oder Calcit-Kristalle in Frage. Polarisationsfolien haben den Nachteil, daß sie den Großteil der einfallenden Strahlung absorbieren, was bei Einstrahlung mit hohen Intensitäten und insbesondere mit einem hohen UV-Anteil zur schnellen Zerstörung der molekularen Struktur der Folie führt. Strahlteilerwürfel und Calcit-Kristalle sind bei großen Aperturen so teuer, daß ein wirtschaftlicher Einsatz ausgeschlossen ist.

Die Erfindung befaßt sich daher mit einem weiteren bekannten Phänomen der Polarisation von Licht, nämlich der Polarisation durch Lichtbrechung und Reflexion an lichtbrechenden Oberflächen, insbesondere von planparallelen, Glasplatten.

Die Lichtanteile von S- und P-Polarisation werden unterschiedlich stark gebrochen und mit unterschiedlichen Intensitätsanteilen reflektiert. Für die unterschiedlichen Intensitätsanteile gelten die Fresnell'schen Gleichungen, aus denen folgt, daß die Reflexion der P-Polarisation unter dem sogenannten Brewster-Winkel verschwindet, das reflektierte Licht also nur noch einen S-Polarisationsanteil aufweist. Auch bei Einfallswinkeln, die um mehrere Grad vom Brewster-Winkel abweichen, verschwindet der Reflexionsanteil der P-Polarisation noch fast vollständig. Es genügt also, wenn der Einfallswinkel im Bereich des Brewster-Winkels liegt.

Aus der GB 2 272 277 A ist eine Vorrichtung zur S-Polarisation von Licht mittels einer Anordnung von planparallelen Platten unter dem Brewster-Winkel bekannt, wobei die Platten im großen Abstand nebeneinander stehen, um eine möglichst große Fläche einer optischen Anzeige mit polarisiertem Licht zu bestrahlen. Die große Zahl der Platten dient dabei zur Vergrößerung der bestrahlten Fläche. Das von den Platten reflektierte Licht wird nach nochmaliger Reflexion an einem Spiegel in den Strahlengang zurückgeführt, um die S-Polarisation zu erzielen.

Aus der FR 2 693 561 A1 ist ebenfalls eine Vorrichtung zur Polarisation von Licht mittels Anordnung einer planparallelen Platte unter dem Brewster-Winkel bekannt, bei der auch das zunächst an der Platte reflektierte Licht durch eine weitere Reflexion in den den Strahlengang zurückgeführt wird.

Der unter dem Brewster-Winkel reflektierte Intensitätsanteil ist zwar frei von P-Polarisation und daher vollständig S-polarisiert, nutzt aber nur einen kleineren Teil der möglichen Intensität aus. Bei Glas mit einem Brechungsindex von n = 2 berechnet sich der Brewster-Winkel zu 64° und der reflektierte Anteil der S-Polarisation bei 64° zu 36%. Im Vergleich hiermit erreichen Polarisationsfolien 70%, Calcit-Kristalle 95% und Strahlteilerwürfel sogar 98%.

Will man dagegen den unter dem Brewster-Winkel (theoretisch) zu 100% transmittierten Anteil der P-Polarisation nutzen, so hat man den Nachteil, daß auch ein großer Teil (in unserem Beispiel mit nur einer lichtbrechenden Fläche: 64%) der S-Polarisation transmittiert wird. Man hat daher im transmittierten Strahl nicht einmal annähernd vollständige Polarisation.

Aus der FR 2 654 844 sind verschiedene Polarisatoranordnungen mit mehreren lichtdurchlässigen Platten bekannt, die gegenüber der optischen Achse in dieselbe Richtung geneigt angeordnet sind, wobei der Winkel des einfallenden Lichtes zur jeweiligen Plattennormale im Bereich des Brewster-Winkels liegt. Aus einem Ausführungsbeispiel des genannten Dokuments ist grundsätzlich auch bekannt, die Platten zu einem Stapel anzuordnen, wobei die Platten untereinander parallel angeordnet sind. Dabei wird jedoch keine besonders gute Kontrastleistung erzielt. Ein anderes Ausführungsbeispiel offenbart Platten, die unter geringfügig verschiedenen Winkeln, jedoch in großen Abständen zueinander angeordnet sind. Diese Ausführungsform ist jedoch nicht kompakt aufgebaut.

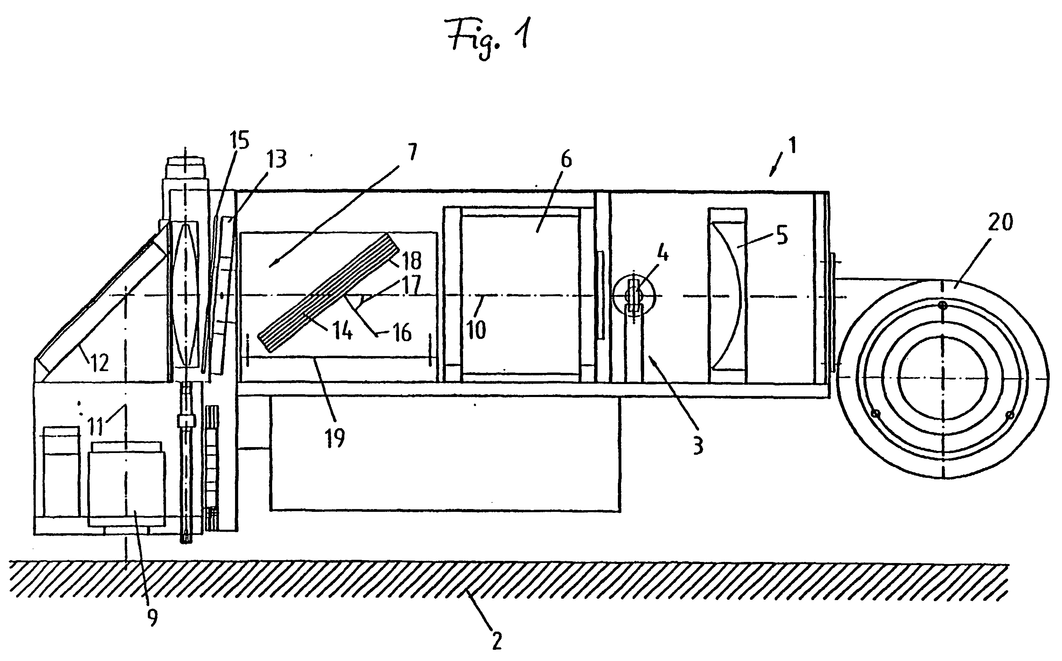

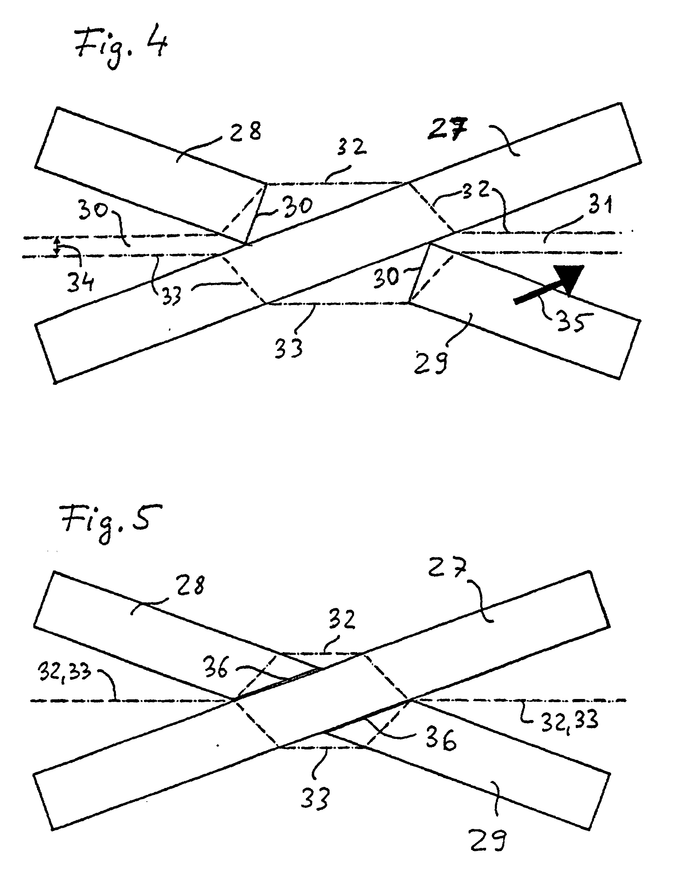

Aus der US 3 439 968, insbesondere den Figuren, sind Polarisatoren mit unter dem Brewster-Winkel zur optischen Achse angeordneten Platten offenbart, wobei stets zwei Platten gegenüber der optischen Achse in entgegengesetzte Richtungen geneigt sind. Die bekannten Anordnungen haben ebenfalls keinen einfachen und kompakten Aufbau. Bei den Ausführungsbeispielen gemäß Figuren 1 bis 5 sind zumindest zwei in entgegengesetzte Richtungen geneigte Platten im Strahlengang hintereinander angeordnet. Dies ergibt eine Baulänge, die in etwa der Längenausdehnung zweier Platten entspricht und daher nicht mehr als kompakt gelten kann. Figur 4a offenbart eine X-förmige Anordnung, die abgesehen von ihrer relativ großen Baulänge zur Erzielung der X-Formation nicht einfache Platten verwendet, sondern zwei V-förmig geknickte optische Bauelemente, für deren Herstellung ein erheblicher Aufwand erforderlich ist.

Aufgabe der Erfindung ist es, eine Polarisatoranordnung der eingangs genannten Art zu verbessern, so daß bei einfachem und kompaktem Aufbau ein höherer Kontrast erzielt wird.

Diese Aufgabe wird erfindungsgemäß dadurch gelöst, daß die Platten innerhalb des Stapels unter geringfügig verschiedenen Winkeln fächerartig angeordnet sind und/oder die Platten einen keilförmigen Querschnitt aufweisen und daß die Platten in Richtung des einfallenden Lichtes der Lichtquelle fortschreitend unter jeweils abnehmenden Winkeln zur optischen Achse angeordnet sind.

Beim Durchtritt durch die einzelnen Platten des Plattenstapels wird der Lichtanteil mit P-Polarisation jeweils (unter Vernachlässigung von Absorptionseffekten) zu 100% transmittiert; er erfährt also beim Durchtritt durch den gesamten Plattenstapel keine wesentliche Abschwächung, wenn die Anzahl der Platten nicht zu groß ist. Vom Lichtanteil mit S-Polarisation wird an jeder Platte ein kleinerer Teil reflektiert und damit aus dem Strahlengang entfernt. Je größer die Anzahl der Platten desto geringer ist der verbleibende Anteil von S-Polarisation und desto vollständiger die Polarisation des transmittierten Strahls.

Die erfindungsgemäße Maßnahme hat den Vorteil, daß die zwischen den Platten hin und her reflektierten S-Polarisationsanteile den Plattenstapel nach weniger Reflexionen seitlich verlassen und vollständiger aus dem Strahlengang herausgelenkt werden. Dadurch sind weniger Platten erforderlich, um die verbleibende Intensität der S-Polarisation im transmittierten Strahl auf ein tolerierbares Maß zu vermindern. In analoger Weise funktioniert es auch, wenn die Platten selbst keilförmig sind. Am wirkungsvollsten ist, wenn sowohl der Spalt als auch die Platte keilförmig ausgebildet wird.

Jeder transmittierte Strahl, der zwei Reflexionen hinter sich hat - also insbesondere der überwiegende Anteil der transmittierten Strahlen mit S-Polarisation - verläuft hier unter einem Winkel zur optischen Achse, der doppelt so groß ist wie die Winkeldifferenz der beteiligten aufeinanderfolgender Platten. An jeder weiteren Platte, die erfindungsgemäß einen noch kleineren Winkel mit der optischen Achse einschließt, wird der abermals transmittierte Strahl wieder hauptsächlich reflektiert, wobei sich sein Winkel zur optischen Achse schnell vergrößert, bis er schließlich nach wenigen Platten seitlich aus dem Plattenstapel austritt.

Insbesondere gilt aber auch, daß jeder transmittierte Strahl, der mindestens eine Reflexion hinter sich hat, den Plattenstapel unter einem Winkel zur optischen Achse verläßt, der mindestens so groß ist wie der doppelte Winkelabstand der beiden beteiligten oder benachbarten Platten des Stapels. Diesen Umstand kann man nutzen, um den Polarisationsgrad zu erhöhen, insbesondere wenn die einfallenden Strahlen kollimiert sind. Dazu wählt man die Winkeldifferenz der beiden benachbarten Platten des Plattenstapels größer als die Hälfte des Akzeptanzwinkels einer im Strahlengang nachfolgenden optischen Anordnung, mit der Folge, daß alle transmittierten Strahlen, die wenigstens eine Reflexion im Plattenstapel hinter sich haben, die optische Anordnung nicht passieren können. Nur noch die ohne Reflexion direkt transmittierten Strahlen, bei denen die P-Polarisation deutlich überwiegt, gelangen in den weiteren Strahlengang.

Besonders gute Ergebnisse mit den fächerartigen Plattenstapeln erzielt man, wenn die Winkeldifferenz zweier benachbarter Platten mindestens 2°, insbesondere zwischen 4° und 6° beträgt.

In einer alternativen Ausgestaltung der Erfindung ist vorgesehen, daß zwei, vorzugsweise planparallele, Platten gegenüber der optischen Achse in entgegengesetzten Richtungen geneigt angeordnet sind, wobei die jeweilige Plattennormale im wesentlichen im Brewster-Winkel zur optischen Achse steht. Diese Anordnung hat den Vorteil, daß beide Platten beliebig genau unter dem Brewster-Winkel geneigt sein können und trotzdem nur die ohne Reflexion direkt transmittierten Strahlen im kollimierten Strahlengang verbleiben.

Wenn die beiden Platten in genau entgegengesetzte Richtungen geneigt sind, ergibt sich ein weiterer Vorteil. Eine durch die erste schrägstehende Platte hervorgerufene Verschiebung des Strahlengangs, die eine Fokusverschiebung zur Folge hätte, wird durch die zweite, entgegengesetzt schrägstehende Platte vollständig wieder aufgehoben. Bei einem Einsatz in einem fokussierten Strahlteil ist die Parallelverschiebung abhängig vom Einfallswinkel und damit vom Abstand zur optischen Achse. Im Gegensatz zu einer fächerförmigen Anordnung, in der sich die Verschiebungen aufaddieren, kompensieren sie sich in dieser Anordnung weitgehend, wenn auch nicht vollständig. Dies verbessert die Abbildungsqualität.

Einen symmetrischen Strahlengang und eine kompakte Anordnung des Polarisators erhält man durch die Maßnahme, daß eine der beiden Platten in zwei Plattenteile aufgeteilt ist und daß die beiden Plattenteile zusammen mit der anderen, ungeteilten Platte X-förmig angeordnet sind.

Ein an der Nahtstelle der X-förmigen Anordnung auftretender lichtundurchlässiger Bereich (dunkler Streifen) kann in der Breite etwa halbiert werden, wenn die beiden Plattenteile aus der gemeinsamen Plattenebene heraus jeweils zur optischen Achse hin geringfügig parallelversetzt angeordnet sind.

Der dunkle Streifen verschwindet vollständig, wenn die beiden Plattenteile an ihren der ungeteilten Platte nächstliegenden Schmalseiten mit einer Fase versehen sind, wobei sie nicht mehr parallelversetzt angeordnet werden.

Da bei Einsatz in einem fokussierten Strahlteil, der Einfallswinkel vom Abstand zur optischen Achse abhängig ist, was die Polarisationswirkung entsprechend beeinflußt, ist es besonders vorteilhaft, wenn der Polarisator eine solche Wölbung aufweist, daß der Einfallswinkel des konvergent auf die Platte einfallenden Lichtes in etwa unabhängig vom Ort gleichbleibend ausgebildet ist. Ein solcher Polarisator kann, ja nach optischen Erfordernissen, sowohl eindimensional oder auch zweidimensional gewölbt sein. Zwei solcher Polarisatoren lassen sich X-förmig anordnen, wobei die zuvor erläuterten Vorteile erreicht werden können.

Mit besonderem Vorteil wird der Erfindungsgedanke in Verbindung mit einem Projektionsapparat realisiert, der eine Lichtquelle, eine Bilderzeugungseinheit und eine Abbildungsoptik aufweist, wobei die Bilderzeugungseinheit als Flüssigkristallbildschirm mit einem im Strahlengang davor angeordneten ersten Polarisator und einem dahinter angeordneten zweiten Polarisator, dem Analysator, ausgebildet ist.

Solche Projektionsapparate werden beispielsweise zur Projektion von Videobildern verwendet, wobei die Brillianz des Projektionsbildes durch ein Anteil von ultraviolettem Licht im Strahlengang verbessert werden kann.

Weiterhin verwendet man derartige Projektionsapparate in Vorrichtungen zur photomechanischen Herstellung strukturierter Oberflächen, beispielsweise zum Belichten von Druckplatten, wo sie insbesondere in einen verfahrbaren Belichtungskopf eingebaut werden.

Eine derartige Vorrichtung ist aus der WO 95/22787 bekannt. Mit der bekannten Vorrichtung werden Offset-Druckplatten belichtet, indem die Vorlage auf elektronischem Weg in Teilbilder zerlegt wird und die Teilbilder nacheinander auf einem Flüssigkristallbildschirm so dargestellt und auf die Druckplatte abgebildet werden, daß sich die Abbilder zu einem Gesamtbild der Vorlage vereinigen. Dabei wird der Belichtungskopf von einer Belichtungsstelle zur nächsten verfahren, während gleichzeitig die Darstellung auf dem Flüssigkristallbildschirm von einem Teilbild zum nächsten wechselt. Zur Belichtung der gesamten Druckplatte muß eine große Zahl von Teilbildern belichtet werden. Dabei kann sich die Gesamtbelichtungszeit für die vollständige Belichtung der Druckplatte unakzeptabel verlängern.

Prinzipiell kann die Belichtungszeit verkürzt werden, indem für die Belichtung höhere Lichtintensitäten verwendet werden. Höhere Lichtintensitäten führen aber bei dem engen Aufbau des Belichtungskopfes zu einer nicht mehr tolerierbaren Wärmebelastung, insbesondere wenn für die erforderliche Polarisierung des in den Flüssigkristallbildschirm fallenden Lichtes eine Polarisationsfolie verwendet wird. Wie bereits erwähnt lassen derartige Polarisationsfilter den einen Teil des einfallenden Lichtes mit der erwünschten Polarisationsrichtung überwiegend durch, während der verbleibende Teil mit der unerwünschten Polarisationsrichtung absorbiert wird. Bei hohen Lichtintensitäten entsteht daher im Polarisationsfilter eine erhebliche Wärmemenge, die abgeführt werden muß, um eine Zerstörung des Polarisationsfilters zu vermeiden.

Wenn nun zumindest der erste Polarisator eines derartigen Projektionsapparates gemäß der vorliegenden Erfindung ausgebildet ist, so wird zumindest ein wesentlicher Anteil - in der Regel etwa die Hälfte - der nicht für die Abbildung verwendeten Intensität des einfallenden Lichtes (mit der unerwünschten Polarisationsrichtung) durch Reflexion aus dem Strahlengang herauslenkt. Andererseits wird der für die Abbildung verwendbare Lichtanteil (mit der erwünschten Polarisationsrichtung) im wesentlichen transmittiert.

Da weniger Absorption stattfindet, gewährleistet die erfindungsgemäße Ausgestaltung eine geringe thermische Belastung des Polarisators. Das herausgelenkte Licht wird außerhalb der Bilderzeugungseinheit an einer anderen Stelle absorbiert, wo sich die deponierte Wärme weniger schädlich auswirken kann.

Als Folge der Erfindung können höhere Lichtintensitäten verwendet werden. Der Projektionsapparat kann somit ein helleres und brillianteres Projektionsbild erzeugen. Bei einer Belichtungsvorrichtung können die Belichtungszeiten verkürzt werden. Der Kontrast wird verbessert.

Ein erfindungsgemäßer Projektionsapparat, der einen aus fächerartig unter abnehmenden Winkeln zur optischen Achse angeordneten Platten bestehenden Polarisator aufweist, kann dadurch noch verbessert werden, daß die Winkeldifferenz zwischen je zwei Platten der fächerartigen Anordnung größer als die Hälfte des Akzeptanzwinkels der Abbildungsoptik ist. Auf diese Weise wird sichergestellt, daß nur direkt ohne Reflexion transmittierte Strahlen die Abbildungsoptik passieren können.

In einer einfachen Ausgestaltung des Projektionsapparates besteht der zweite Polarisator aus einem Polarisationsfilter in Form einer Folie. Im Bereich des zweiten Polarisators fällt der Vorteil eines geringen Bauraums des Polarisationsfilters mehr ins Gewicht als die zusätzliche Wärmeerzeugung durch Absorption, die im übrigen hier wesentlich geringer ist als beim ersten Polarisator. Bessere Kontrastwerte erhält man jedoch, wenn auch für den zweiten Polarisator die erfindungsgemäße Form gewählt wird.

Der Kontrast wird noch verbessert, wenn der Flüssigkristallbildschirm (13) zur optischen Achse um einen Winkel geneigt ist, der dem Winkel der besten Transmission entspricht, insbesondere die Flächennormale des Flüssigkristallbildschirms zwischen 3° und 6° gegenüber der optischen Achse geneigt ist.

In einer besonders zur Verwendung in einem Belichtungskopf geeigneten Ausgestaltung des Projektionsapparates ist vorgesehen, daß die Lichtquelle eine Metallhalogenitlampe, einen Reflektor und einen Kollimator umfaßt. Der für die Belichtung allein wirksame UV-Anteil der Metallhalogenitlampe ist hoch, während der nicht nutzbare Spektralbereich eine relativ geringe Intensität aufweist. Daraus ergibt sich eine geringere Wärmebelastung der nachfolgenden Bilderzeugungseinheit. Reflektor und Kollimator ermöglichen die Nutzung eines großen Raumwinkelanteils des von der Lampe abgestrahlten Lichtes, so daß weniger ungenutztes Licht in Wärme umgewandelt wird.

In einer vorteilhaften Ausführungsform ist im Strahlengang zwischen der Lichtquelle und der Bilderzeugungseinheit ein UV-durchlässiger Filter angeordnet. Ein solcher Filter hält weitere Lichtintensität im nicht nutzbaren Spektralbereich zurück, so daß es nicht in die Bilderzeugungseinheit fällt und nicht zur Wärmebelastung der Bilderzeugungseinheit beitragen kann.

Ein UV-durchlässiger Filter absorbiert aber das Licht im nicht durchgelassenen Spektralbereich, wobei die Lichtenergie zwar nicht in der Bilderzeugungseinheit aber im UV-Filter in Wärme verwandelt wird. Zur Behebung dieses Nachteils wird als Alternative zur Weiterbildung der Erfindung vorgeschlagen, daß zwischen der Lichtquelle und der Bilderzeugungseinheit ein UV-durchlässiges optisches Element angeordnet ist, das einen wesentlichen Teil der Lichtintensität im nicht nutzbaren Spektralbereich reflektiert. Mit Vorteil ist dadurch die Wärmeerzeugung im optischen Element reduziert. Das nicht nutzbare, reflektierte Licht kann an anderer Stelle absorbiert werden, wo die dabei erzeugte Wärme nicht mehr stört.

Der erfindungsgemäße Belichtungskopf kann durch ein Kühlgebläse noch verbessert werden. Das Kühlgebläse sorgt mit Vorteil für eine wirkungsvolle Abfuhr der deponierten Wärme.

Weitere Vorteile und Einzelheiten der Erfindung ergeben sich aus der nachfolgenden Beschreibung von Ausführungsbeispielen anhand der Zeichnungen.

Die Figuren zeigen im einzelnen:
- Figur 1:: eine teilweise geschnittene Darstellung eines erfindungsgemäß ausgestalteten Belichtungskopfes,
- Figur 2:: Transmission und Reflexion an einer planparallelen Platte,
- Figur 3:: Transmission und Reflexion bei zwei gegeneinander geneigten Platten,
- Figur 4:: planparallele Platten in X-förmiger Anordnung,
- Figur 5:: wie Figur 4, mit angefasten Plattenkanten,
- Figur 6:: planer Polarisator im konvergenten Licht,
- Figur 7:: gewölbter Polarisator im konvergenten Licht.

In Figur 1 erkennt man einen Belichtungskopf 1, der mittels einer nicht gezeigten Vorrichtung auf einer Unterlage 2 motorisch verfahrbar angeordnet ist. Der Belichtungskopf 1 besitzt eine Lichtquelle 3, die aus einer Metallhalogenitlampe 4, einem Reflektor 5 und einem Kollimator 6 besteht. Der Kollimator 6 enthält eine nicht gezeigte Linsenoptik, die das für die Belichtung vorgesehene Licht weitgehend parallel ausrichtet. Weiterhin umfaßt der Belichtungskopf 1 eine Bilderzeugungseinheit 7 bzw. 8 und eine Abbildungsoptik 9, mittels derer die in der Bilderzeugungseinheit 7 erzeugte Bildvorlage auf eine nicht gezeigte Druckplatte auf der Unterlage 2 im verkleinerten Maßstab projeziert und abgebildet werden kann. Für eine bessere Handhabbarkeit ist der Belichtungskopf 1 im wesentlichen liegend über der Unterlage 2 angeordnet. Das für die Belichtung verwendete Licht hat ursprünglich einen Strahlengang mit einer horizontalen optischen Achse 10. Für die Abbildung auf der Unterlage 2 ist eine optische Achse 11 der Abbildungsoptik 9 vertikal ausgerichtet. Für die Umlenkung des Strahlengangs aus der Horizontalen in die Vertikale ist ein Spiegelelement 12 vorgesehen.

Die Bilderzeugungseinheit 7 besteht aus einem Flüssigkristallbildschirm 13, einem im Strahlengang davor angeordneten ersten Polarisator 14 und einem im Strahlengang dahinter angeordneten zweiten Polarisator 15. Der erste Polarisator 14 arbeitet nach dem Prinzip der Reflexion im Brewster-Winkel. Er wird nachfolgend genauer beschrieben.

Der in Figur 1 abgebildete Polarisator besteht aus einem Stapel planparalleler Platten, der im Strahlengang derart schräg angeordnet und befestigt ist, daß ein Lot 16 auf jede Plattenfläche mit der optischen Achse 10 in etwa den Brewster-Winkel 17 bildet. Diese Anordnung hat zur Folge, daß im Strahlengang nach dem ersten Polarisator 14 im wesentlichen nur noch polarisiertes Licht auf den Flüssigkristallbildschirm 13 fällt. Das vom ersten Polarisator 14 nicht durchgelassene Licht wird für die Belichtung der Druckplatte nicht verwendet. Es wird an den Oberflächen der planparallelen Platten und überwiegend an der ersten Oberfläche 18 reflektiert und fällt im wesentlichen auf eine seitliche Wand 19, wo es im wesentlichen absorbiert wird. Die an der seitlichen Wand 19 entstehende Wärme kann relativ leicht abgeführt werden. Für eine ausreichende Wärmeabfuhr sorgt ein seitlich am Gehäuse des Belichtungskopfes 1 angebrachtes Gebläse 20.

Das vom ersten Polarisator 14 polarisierte Licht tritt durch den Flüssigkristallbildschirm 13 hindurch, der entsprechend der abzubildenden Bildvorlage in bestimmten Flächenbereichen die Polarisationsebene des einfallenden Lichtes mehr oder weniger dreht. Das so modulierte Lichtbündel fällt dann auf den zweiten Polarisator 15, der je nach Drehung der Polarisationsebene in den betroffenen Flächenbereichen ein Hell-Dunkel-Muster erzeugt. Damit ist die Bildvorlage geeignet für die Abbildung über das Spiegelelement 12 und mittels der Abbildungsoptik 9 auf die Druckplatte.

Der zweite Polarisator 15 besteht aus einem gebräuchlichen Polarisationsfilter in Form einer Folie. Zwar tritt bei einer derartigen Polarisationsfolie wieder der Nachteil auf, daß das nicht durchgelassene Licht absorbiert und somit Wärme erzeugt wird, jedoch ist die zu absorbierende Lichtintensität am zweiten Polarisator 15 sehr viel geringer als die am ersten Polarisator 14, so daß die erzeugte Wärmemenge hier noch tolerierbar ist, jedenfalls nicht immer bzw. nicht in jedem Fall den Aufwand für die Anordnung eines Stapels planparalleler Platten wie beim ersten Polarisator 14 rechtfertigt.

Im Strahlengang zwischen der Metallhalogenitlampe 4 und dem Flüssigkristallbildschirm 13 könnte mit Vorteil ein UV-durchlässiger Filter oder ein UV-durchlässiges optisches Element angeordnet sein, das einen wesentlichen Teil der Lichtintensität im nicht nutzbaren Spektralbereich aus dem Strahlengang herausnimmt und dabei die Wärmebelastung der nachfolgenden optischen Elemente, insbesondere des Flüssigkristallbildschirms 13 und des zweiten Polarisators 15 verringert.

In Figur 2 ist die Situation von Transmission und Reflexion des Lichtanteils mit S-Polarisation an einer Platte 21 erläutert. Ein parallel zur optischen Achse 23 einfallender Strahl 24 trifft mit der Intensität Iₒ an einer Stelle ⓪ auf eine Oberfläche 25 der Platte 21, wo er sich in zwei Teilstrahlen aufteilt. Am Luft-Glas-Übergang der Oberfläche 25 wird ein Teilstrahl mit der Intensität R₀ reflektiert und tritt im Idealfall seitlich aus dem Bereich des Polarisators 14 aus. Ein anderer Teilstrahl wird gebrochen und mit der Intensität Tₒ transmittiert.

Der transmittierte Teilstrahl trifft an der Stelle ① auf die gegenüberliegende Oberfläche 26 der Platte 21, die hier einen Glas-Luft-Übergang darstellt, und wird in weitere Teilstrahlen aufgeteilt. Ein Teilstrahl davon wird gebrochen - diesmal in die entgegengesetzte Richtung - und tritt mit der Intensität T₁ parallel zur optischen Achse 23 aus der Platte 21 aus. Der andere Teilstrahl wird ins Innnere der Platte 21 zurück reflektiert, bis er an der Stelle ② wieder auf die Oberfläche 25 trifft, die diesmal einen Glas-Luft-Übergang darstellt. Auch hier wird wieder ein Teilstrahl mit der Intensität T₂ transmittiert und gebrochen, so daß er parallel zu dem ersten reflektierten Teilstrahl R₀ seitlich aus dem Polarisator austreten kann.

Wie man aus der Figur 2 leicht erkennt, wird der verbleibenden Teilstrahl an den Stellen ② bis ⑦ immer wieder zwischen den Oberflächen 25 und 26 der Platte 21 hin und her reflektiert, wobei seine Intensität von R₂ bis R₇ und darüber hinaus immer weiter abnimmt. Insgesamt werden dabei die Teilstrahlen R₀ und T₂, T₄, T₆, ...(alle mit geraden Nummern) aus dem Strahlengang herausgelenkt, während die Teilstrahlen T₁, T₃, T₅, T₇, ...(alle mit ungeraden Nummern) im Strahlengang verbleiben und die nächste Platte des Plattenstapels erreichen können. Auf diese Weise entsteht eine nachteilig ungleichmßige Intensitätsverteilung.

Ein P-polarisierter Strahl, der unter dem Brewster-Winkel 17 zum Lot 16 auf die Platte 21 trifft, wird nicht in Teilstrahlen aufgeteilt, weil die Intensitäten der reflektierten Teilstrahlen verschwinden. In diesem Fall wird der einfallende Strahl an den Stellen ⓪ und ① jeweils nur gebrochen und tritt mit (im wesentlichen) unverminderter Intensität aus der Platte 21 aus.

In einer theoretischen Berechnung der verbleibenden Intensität der S-Polarisation kann man die aus der Oberfläche 26 der Platte 21 austretenden Teilintensitäten aufsummieren. Bei einem Brechungsindex von n = 2 ergibt die Berechnung, daß etwa 47% der einfallenden Intensität durch die Platte 21 hindurchtritt. Da (im Idealfall) 100% der P-Polarisätion transmittiert wird, beträgt das Verhältnis von P-Polarisation zu S-Polarisation nach dem Durchgang etwas mehr als 2:1.

In einem Plattenstapel, bei dem alle Platten unter demselben Winkel ausgerichtet sind, kommt es zwischen den Platten zu weiteren Reflexionen, so daß sich bezüglich der aus dem Plattenstapel austretenden Intensität der S-Polarisation eine weit kompliziertere Situation ergibt. Es kann daher nicht einfach von einer Platte auf den Plattenstapel hochgerechnet werden. Unter weiteren idealisierenden Annahmen kann man aber abschätzen, daß etwa 88 Platten erforderlich wären, um das oben genannte Verhältnis auf 100:1 zu verbessern.

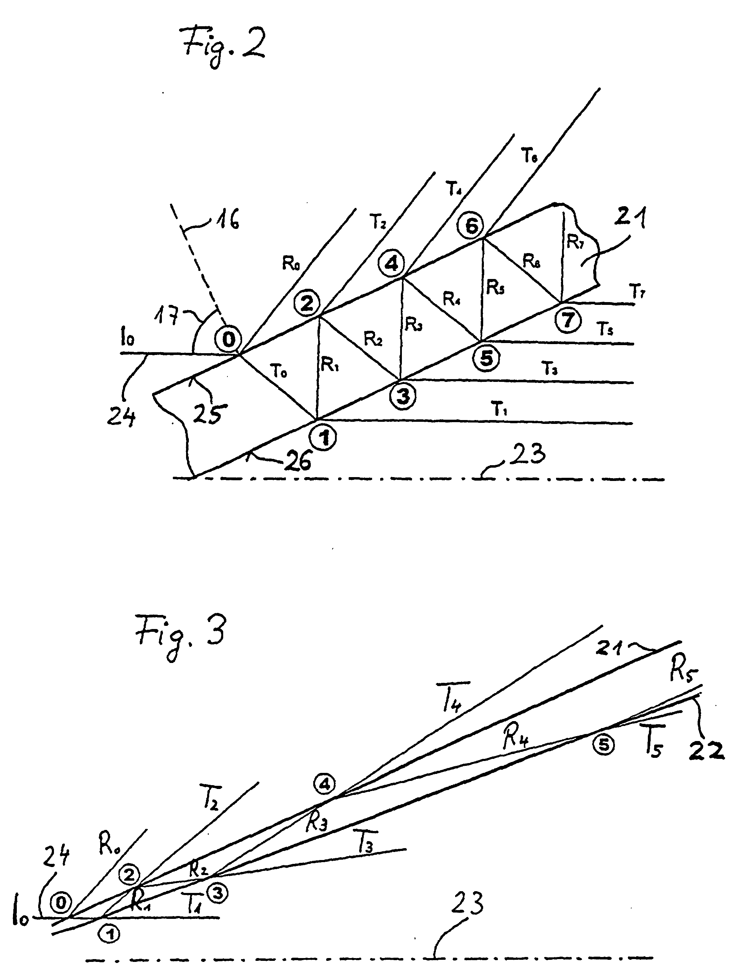

Eine bessere Möglichkeit zur Reduzierung des Intensitätsanteils der S-Polarisation ist in Figur 3 dargestellt. Hier sind zwei Platten 21 und 22 unter geringfügig verschiedenen Winkeln zur optischen Achse 23 aufgestellt. Ein von links parallel zur optischen Achse 23 mit der Intensität Iₒ einfallender Strahl 24 tritt an der Stelle ⓪ durch die erste Platte 21 und an der Stelle ① durch die zweite Platte 22 hindurch, wobei er jeweils geringfügig parallelversetzt wird. Ein Teilstrahl R₁ wird an der Stelle ① aber auch reflektiert und trifft an der Stelle ② wieder auf die erste Platte 21, wo wiederum ein Teilstrahl R₂ zur zweiten Platte 22 reflektiert wird. Die Reflexionen zwischen den Platten 21 und 22 setzen sich an den Stellen ③, ④, ⑤, ... mit den Teilstrahlen R₃, R₄, R₅, ... fort.

Da die Platten 21 und 22 nicht parallel zueinander angeordnet sind, werden die Winkel zwischen den Platten 21,22 und den reflektierten Teilstrahlen von einer Reflexion zur nächsten immer kleiner, wobei die Abstände zwischen den Reflexionsstellen zunehmen. Nach einer endlichen Zahl von Reflexionen liegt der Winkel des reflektierten Strahls im Bereich zwischen den Winkeln der ersten Platte 21 und der zweiten Platte 22, so daß der Strahl den Plattenstapel seitlich verlassen kann. Dadurch wird ein weiterer Intensitätsanteil der S-Polarisation aus dem nachfolgenden Strahlengang entfernt.

Wenn man nun alle Platten in einem Plattenstapel unter geringfügig verschiedenen Winkeln anordnet, wobei die Winkel zur optischen Achse 23 von einer zur nächsten Platte abnehmen, so ergibt sich für die an den Stellen ②, ④, ... "zurücktransmittierten" Strahlen T₂, T₄, ... dieselbe Situation wie für die beschriebenen reflektierten Teilstrahlen R₁, R₂, R₃, R₄, R₅, ... : sie treten nach endlich vielen Reflexionen seitlich aus dem Polarisator 14 aus.

Aber auch die durch die letzte Platte 22 hindurchtretenden Teilstrahlen T₃, T₅, T₇, ..., die beim Durchgang durch den Plattenstapel mindestens eine Doppelreflexion erfahren haben können auf einfache Weise aus dem weiteren Strahlengang entfernt werden, weil sie aufgrund der Reflexionen an den Stellen ②, ④, ... nicht mehr parallel zur optischen Achse 23 verlaufen. Der (minimale) Winkel zur optischen Achse ist nach einmaliger Reflexion an der Stelle ② doppelt so groß wie die Winkeldifferenz der beiden beteiligten Platten 21 und 22, nach mehrmaliger Reflexion entsprechend größer.

Wenn man nun die Winkeldifferenz zwischen zwei benachbarten Platten größer wählt als den Akzeptanzwinkel von beispielsweise 4° der nachfolgend angeordneten Abbildungsoptik 9, so können keine Teilstrahlen; die beim Durchgang durch den Plattenstapel mindestens eine Doppelreflexion erfahren haben, zur Bildentstehung beitragen. Nur noch die ohne Reflexion direkt transmittierten Strahlen T₁ können in den weiteren Strahlengang gelangen.

Dies bedeutet aber, daß man im Fall von fächerartig angeordneten Platten aus dem Intensitätsverhältnis der P-Polarisation zur S-Polarisation nach Transmission durch eine einzige Platte auf das Intensitätsverhältnis nach Transmission durch den gesamten Plattenstapels hochrechnen kann, indem man einfach die Einzelverhältnisse miteinander multipliziert.

Unter denselben Voraussetzungen wie beim obigen Beispiel (Brechungsindex n = 2; Transmission der S-Polarisation durch eine Platte: 47%; Transmission der P-Polarisation: 100%) kann man abschätzen, daß bei der gefächerten Anordnung nur noch 6 bis 7 Platten erforderlich wären, um das oben genannte Verhältnis auf 100:1 zu verbessern, im Gegensatz zu 88 Platten beim ungefächerten Plattenstapel.

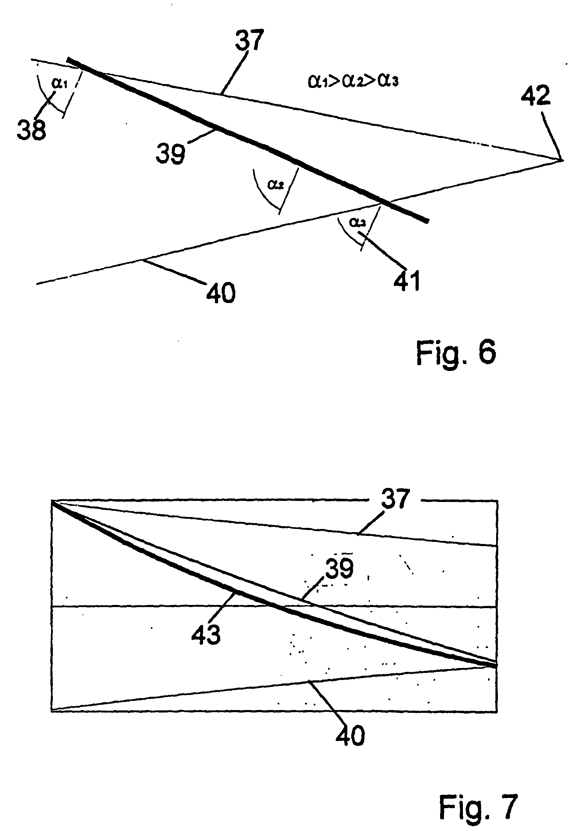

Prinzipiell kann man dasselbe Ergebnis hinsichtlich der Multiplikation der Intensitätsverhältnisse der einzelnen Platten auch mit einer abgewandelten Plattenanordnung erzielen, die in den Figuren 4 und 5 dargestellt ist.

Eine erste Platte 27 ist in bekannter Anordnung unter dem Brewster-Winkel zu den einfallenden Strahlen aufgestellt. Dies gilt auch für eine zweite Platte, die jedoch in zwei Plattenteile 28 und 29 unterteilt ist. Das eine Plattenteil 28 ist dabei auf der einen Seite, das andere Plattenteil 29 auf der anderen Seite der Platte 27 angeordnet, so daß insgesamt eine X-förmige Anordnung entsteht.

Diese Anordnung hat den Vorteil, daß alle Platten 27,28,29 genau unter dem Brewster-Winkel angeordnet sein können und deshalb beste Voraussetzungen für eine vollständige Transmission der P-Polarisation bieten.

Da die beiden Plattenteile 28,29 bei der in Figur 4 dargestellten Anordnung im einfachsten Fall jeweils eine gerade geschnittene Schmalseite 30 besitzen, entsteht an der Nahtstelle, an der die Plattenteile 28,29 auf die erste Platte 27 treffen, ein lichtundurchlässiger Bereich 31. Wie man in der Zeichnung am Beispiel der gerade noch durchgehenden Grenzstrahlen 32 und 33 erkennen kann, werden aber die Strahlen durch die Brechung an den Platten 27,28,29 auf vorteilhafte Weise um die Nahtstelle herumgelenkt, so daß die Dicke 34 des lichtundurchlässigen Bereichs sehr viel kleiner als die Plattendicke ausfällt.

Diese Dicke 34 kann noch auf die Hälfte verkleinert werden, wenn man die beiden Plattenteile 28,29, wie in der Zeichnung durch den Pfeil 35 angedeutet, parallel zueinander verschiebt.

Man kann den lichtundurchlässigen Bereich auch ganz verschwinden lassen, wenn man die Schmalseiten der beiden Plattenteile 28,29 wie in Figur 5 gezeigt an der Nahtstelle jeweils mit eine Fase 36 versieht.

Die Verhältnisse stellen sich anders dar, wenn statt paralleles Licht nun konvergentes Licht betrachtet wird. Dann verändert sich nämlich der Einfallswinkel des Lichtes auf einem planen Polarisator in Abhängigkeit des Ortes.

Diese Verhältnisse sind in Fig. 6 schematisch dargestellt. Ein oberer Lichtstrahl 37 fällt mit einem anderen, d.h. größeren Winkel 38 zur Flächennormalen eines planen Polsarisators 39 ein als ein unterer Lichtstrahl 40. Dieser trifft in einem kleineren Winkel 41 zur Flächennormalen in Richtung auf den Brennpunkt auf. Daraus resultieren unterschiedliche Polarisationswirkungen.

Um dies zu verhindern ist erfindungsgemäß der Polarisator gewölbt, wie er in Fig. 7 dargestellt und mit Bezugsziffer 43 bezeichnet ist. Zum Vergleich ist auch der plane Polarisator 39 in Fig. 7 gezeigt. Beim gewölbten Polarisator, dessen Krümmung für den Fachmann berechenbar ist, fallen alle Lichtstrahlen unabhängig von ihrem Ort unter demselben Winkel zur Flächennormalen ein. Je nach den Erfordernissen der Optik, kann die Wölbung nur in einer Ebene, wie z.B. der Zeichnungsebene, vorgesehen werden, oder auch in zwei Ebenen, so daß sich eine angenähert kugelförmige Wölbung ergibt. Aus der Gegenüberstellung des planen Polarisators 39 und des gewölbten Polarisators 40 in Fig. 7 ist auch erkennbar, daß die gewölbte Platte eine verkürzte Einbaulänge aufweist.

### Bezugszeichenliste

- 1: Belichtungskopf
- 2: Unterlage
- 3: Lichtquelle
- 4: Metallhalogenitlampe
- 5: Reflektor
- 6: Kollimator
- 7: Bilderzeugungseinheit
- 8 9: Abbildungsoptik
- 10: optische Achse
- 11: optische Achse
- 12: Spiegelelement
- 13: Flüssigkristallbildschirm
- 14: erster Polarisator
- 15: zweiter Polarisator
- 16: Lot, Normale
- 17: Winkel
- 18: erste Oberfläche
- 19: seitliche Wand
- 20: Gebläse
- 21: Platte
- 22: Platte
- 23: optische Achse
- 24: einfallender Strahl
- 25: Oberfläche
- 26: Oberfläche
- 27: Platte
- 28: Plattenteil
- 29: Plattenteil
- 30: Schmalseite
- 31: Bereich
- 32: Grenzstrahl
- 33: Grenzstrahl
- 34: Dicke
- 35: Pfeil
- 36: Fase
- 37: oberer Lichtstrahl
- 38: Winkel
- 39: Polarisator
- 40: unterer Lichtstrahl
- 41: kleinerer Winkel
- 42: Brennpunkt
- 43: Polarisator

## Patentansprüche

1. Polarisatoranordnung mit einer Lichtquelle (3) und einem Polarisator (14), insbesondere für die Polarisation von ultraviolettem Licht bei großen Aperturen, mit mehreren lichtdurchlässigen planparallelen Platten (21,22), die gegenüber der optischen Achse (10,23) in dieselbe Richtung geneigt und zu einem Stapel angeordnet sind, wobei der Winkel (17) des einfallenden Lichtes (24) der Lichtquelle (3) zur jeweiligen Plattennormale (16) im Bereich des Brewster-Winkels liegt, wobei die Platten (21,22) innerhalb des Stapels unter geringfügig verschiedenen Winkeln fächerartig angeordnet sind, und wobei die Platten (21,22) in Richtung des einfallenden Lichtes (24) der Lichtquelle (3) fortschreitend unter jeweils abnehmenden Winkeln zur optischen Achse angeordnet sind, wobei unter abnehmenden Winkel der jeweils kleinere Winkel zwischen optischer Achse und Plattenfläche zu verstehen ist.

2. Polarisatoranordnung mit einer Lichtquelle (3) und einem Polarisator (14), insbesondere für die Polarisation von ultraviolettem Licht bei großen Aperturen, mit mehreren lichtdurchlässigen Platten (21,22), die gegenüber der optischen Achse (10,23) in dieselbe Richtung geneigt und zu einem Stapel angeordnet sind, wobei der Winkel (17) des einfallenden Lichtes (24) der Lichtquelle (3) zur jeweiligen Plattennormale (16) im Bereich des Brewster-Winkels liegt, wobei die Platten (21,22) innerhalb des Stapels unter geringfügig verschiedenen Winkeln fächerartig angeordnet sind und die Platten einen keilförmigen Querschnitt aufweisen und wobei die Platten (21,22) in Richtung des einfallenden Lichtes (24) der Lichtquelle (3) fortschreitend unter jeweils abnehmenden Winkeln zur optischen Achse angeordnet sind, wobei unter abnehmenden Winkel der jeweils kleinere Winkel zwischen optischer Achse und Plattenfläche zu verstehen ist.

3. Polarisatoranordnung mit einer Lichtquelle (3) und einem Polarisator (14), insbesondere für die Polarisation von ultraviolettem Licht bei großen Aperturen, mit mehreren lichtdurchlässigen Platten (21,22), die gegenüber der optischen Achse (10,23) in dieselbe Richtung geneigt und zu einem Stapel angeordnet sind, wobei der Winkel (17) des einfallenden Lichtes (24) der Lichtquelle (3) zur jeweiligen Plattennormale (16) im Bereich des Brewster-Winkels liegt, wobei die Platten einen keilförmigen Querschnitt aufweisen und wobei die Platten (21,22) in Richtung des einfallenden Lichtes (24) der Lichtquelle (3) fortschreitend unter jeweils abnehmenden Winkeln zur optischen Achse angeordnet sind, wobei unter abnehmenden Winkel der jeweils kleinere Winkel zwischen optischer Achse und Plattenfläche zu verstehen ist.

4. Polarisatoranordnung nach einem der vorhergehenden Ansprüche wobei die Winkeldifferenz zweier benachbarter Platten (21,22) mindestens 2°, insbesondere zwischen 4° und 6° beträgt.

5. Polarisatoranordnung mit einer Lichtquelle (3) und einem Polarisator (14), insbesondere für die Polarisation von ultraviolettem Licht bei großen Aperturen, mit lichtdurchlässigen, vorzugsweise planparallelen, Platten (27,28,29), deren jeweilige Plattennormale im Brewster-Winkel zu dem im wesentlichen parallel zur optischen Achse einfallenden Licht (32,33) der Lichtquelle (3) steht, wobei zwei Platten (27 und 28,29) gegenüber der optischen Achse in unterschiedliche Richtungen geneigt angeordnet sind, **dadurch gekennzeichnet, daß** eine der beiden Platten in zwei Plattenteile (28,29) aufgeteilt ist und daß die beiden Plattenteile (28,29) zusammen mit der anderen, ungeteilten Platte (27) X-förmig angeordnet sind.

6. Polarisatoranordnung nach Anspruch 5, **dadurch gekennzeichnet, daß** die beiden Plattenteile (28,29) aus der gemeinsamen Plattenebene heraus jeweils zur optischen Achse hin geringfügig parallelversetzt angeordnet sind.

7. Polarisatoranordnung nach Anspruch 5, **dadurch gekennzeichnet, daß** die beiden Plattenteile (28,29) an ihren der ungeteilten Platte (27) nächstliegenden Schmalseiten mit einer Fase (36) versehen sind.

8. Polarisatoranordnung nach einem der vorhergehenden Ansprüche, wobei mindestens eine der Platten eine solche Wölbung aufweist, daß der Einfallswinkel des konvergent auf die Platte einfallenden Lichtes in etwa unabhängig vom Ort gleichbleibend ausgebildet ist.

9. Projektionsapparat mit einer Lichtquelle (3), einer Bilderzeugungseinheit (7, 8) und einer Abbildungsoptik (9), wobei die Bilderzeugungseinheit (7) als Flüssigkristallbildschirm (13) mit einem im Strahlengang davor angeordneten ersten Polarisator (14) und einem dahinter angeordneten zweiten Polarisator (15) ausgebildet ist, **dadurch gekennzeichnet, daß** zumindest der erste Polarisator (14) nach einem der vorhergehenden Ansprüche ausgebildet ist und zumindest einen wesentlichen Anteil der nicht für die Abbildung verwendeten Intensität des einfallenden Lichtes durch Reflexion aus dem Strahlengang herauslenkt.

10. Projektionsapparat nach Anspruch 9 mit einer Polarisatoranordnung nach einem der Ansprüche 5 oder 6, **dadurch gekennzeichnet, daß** die Winkeldifferenz zwischen zwei benachbarten Platten (21,22) der fächerartigen Anordnung größer als die Hälfte des Akzeptanzwinkels der Abbildungsoptik (9) ist.

11. Projektionsapparat nach einem der Ansprüche 9 oder 10, **dadurch gekennzeichnet, daß** der zweite Polarisator (15) aus einem Polarisationsfilter in Form einer Folie oder aus einem Polarisationsfilter gemäß einem der Ansprüche 1 bis 8 besteht.

12. Projektionsapparat nach einem der Ansprüche 9 bis 11, **dadurch gekennzeichnet, daß** der Flüssigkristallbildschirm (13) zur optischen Achse um einen Winkel geneigt ist, der dem Winkel der besten Transmission entspricht, insbesondere die Flächennormale des Flüssigkristallbildschirms zwischen 3° und 6° gegenüber der optischen Achse geneigt ist.

13. Projektionsapparat nach einem der Ansprüche 9 bis 12, **dadurch gekennzeichnet, daß** im Strahlengang zwischen der Lichtquelle (3) und der Bilderzeugungseinheit (7, 8) ein UV-durchlässiger Filter angeordnet ist.

14. Projektionsapparat nach einem der Ansprüche 9 bis 13, **dadurch gekennzeichnet, daß** zwischen der Lichtquelle (3) und der Bilderzeugungseinheit (7, 8) ein UV-durchlässiges optisches Element angeordnet ist, das einen wesentlichen Teil der Lichtintensität im nicht nutzbaren Spektralbereich reflektiert.

15. Vorrichtung zur photomechanischen Herstellung strukturierter Oberflächen, insbesondere zum Belichten von Druckplatten, mit einem verfahrbaren Belichtungskopf (1), **dadurch gekennzeichnet, daß** der Belichtungskopf (1) mit einem Projektionsapparat nach einem der Ansprüche 9 bis 14 versehen ist.

## Claims

1. Polarization arrangement having a light source (3) and a polarizer (14), in particular for the polarization of ultraviolet light at large apertures, having a plurality of light-transparent, plane-parallel plates (21, 22) that are inclined in the same direction to the optical axis (10, 23) and are disposed in a pile, the angle (17) of the incident light (24) of the light source (3) being in the region of the Brewster angle to the normal (16) to the respective plate, wherein the plates (21, 22) are disposed inside the pile in a fan-like manner at slightly different angles, and wherein the plates (21, 22) are disposed in the direction of the incident light (24) of the light source (3) in each case at a progressively decreasing angle to the optical axis, wherein decreasing angle is to be understood as the angle, smaller in each case, between the optical axis and the plate face.

2. Polarization arrangement having a light source (3) and a polarizer (14), in particular for the polarization of ultraviolet light at large apertures, having a plurality of light-transparent plates (21, 22) that are inclined in the same direction to the optical axis (10, 23) and are disposed in a pile, the angle (17) of the incident light (24) of the light source (3) being in the region of the Brewster angle to the respective plate normal (16), wherein the plates (21, 22) are disposed inside the pile in a fan-like manner at slightly different angles and the plates have a wedge-shaped cross section, and wherein the plates (21, 22) are disposed in the direction of the incident light (24) of the light source (3) in each case at a progressively decreasing angle to the optical axis wherein decreasing angle is to be understood as the angle, smaller in each case, between the optical axis and the plate face.

3. Polarization arrangement having a light source (3) and a polarizer (14), in particular for the polarization of ultraviolet light at large apertures, having a plurality of light-transparent plates (21, 22) that are inclined in the same direction to the optical axis (10, 23) and are disposed in a pile, the angle (17) of the incident light (24) of the light source (3) being in the region of the Brewster angle to the respective plate normal (16), wherein the plates (21, 22) are disposed in the direction of the incident light (24) of the light source (3) in each case at a progressively decreasing angle to the optical axis, wherein decreasing angle is to be understood as the angle, smaller in each case, between the optical axis and the plate face.

4. Polarization arrangement according to one of the preceding claims, wherein the angular difference between two adjacent plates (21, 22) is at least 2°, in particular between 4° and 6°.

5. Polarization arrangement having a light source (3) and a polarizer (14), in particular for the polarization of ultraviolet light at large apertures, having transparent, preferably plane-parallel, plates (27, 28, 29) whose respective plate normal is at the Brewster angle to the light (32, 33) of the light source (3) incident essentially parallel to the optical axis, two plates (27 and 28, 29) being disposed so as to be inclined to the optical axis in different directions, **characterized in that** one of the two plates is divided into two plate parts (28, 29) and **in that** the two plate parts (28, 29), together with the other, undivided plate (27) are disposed in an X-shape.

6. Polarization arrangement according to Claim 5, **characterized in that** the two plate parts (28, 29) are disposed so as to be slightly displaced in parallel in each case out of the common plate plane towards the optical axis.

7. Polarization arrangement according to Claim 5, **characterized in that** the two plate parts (28, 29) are provided with a chamfer (36) at their narrow sides situated nearest the undivided plate (27).

8. Polarization arrangement according to one of the preceding claims, wherein at least one of the plates has a curvature such that the angle of incidence of the light convergently incident on the plate is constant in nature approximately independently of the position.

9. Projection apparatus having a light source (3), an image-generating unit (7, 8) and imaging optics (9), the image-generating unit (7) being designed as a liquid-crystal display screen (13) having a first polarizer (14) disposed upstream of it in the beam path and a second polarizer (15) disposed downstream of it, **characterized in that** at least the first polarizer (14) is designed according to one of the preceding claims and at least a substantial component of the intensity, not used for imaging, of the incident light is deflected out of the beam path by reflection.

10. Projection apparatus according to Claim 9, having a polarization arrangement according to one of Claims 5 or 6, **characterized in that** the angular difference between two adjacent plates (21, 22) of the fan-like arrangement is greater than half the acceptance angle of the imaging optics (9).

11. Projection apparatus according to one of Claims 9 or 10, **characterized in that** the second polarizer (15) comprises a polarization filter in the form of a sheet or a polarization filter in accordance with one of Claims 1 to 8.

12. Projection apparatus according to one of Claims 9 to 11, **characterized in that** the liquid-crystal display screen (13) is inclined to the optical axis at an angle that corresponds to the angle of best transmission, in particular the surface normal of the liquid crystal display screen, of between 3° and 6° to the optical axis.

13. Projection apparatus according to one of Claims 9 to 12, **characterized in that** a UV-transparent filter is disposed in the beam path between the light source (3) and the image-generating unit (7, 8).

14. Projection apparatus according to one of Claims 9 to 13, **characterized in that** a UV transparent optical element that reflects a substantial part of the light intensity in the unusable spectral range is disposed between the light source (3) and the image-generating unit (7, 8).

15. Device for the photomechanical production of structured surfaces, in particular for the exposure of printing plates, having a movable exposure head (1), **characterized in that** the exposure head (1) is provided with a projection apparatus according to one of Claims 9 to 14.

## Revendications

1. Dispositif de polarisation comprenant :
une source lumineuse (3) et un polarisateur (14), notamment pour polariser la lumière ultraviolette, pour de grandes ouvertures,
plusieurs plaques (21, 22) planes, parallèles, transparentes, inclinées par rapport à l'axe optique (10, 23) dans la même direction et empilées,
l'angle (17) de la lumière incidente (24) fournie par la source lumineuse (3) étant situé dans la plage de l'angle de Brewster par rapport à la normale (16) d'une plaque,
les plaques (21, 22) étant réparties en forme d'éventail, suivant des angles légèrement différents à l'intérieur de la pile et
les plaques (21, 22) sont disposées dans la direction de la lumière incidente (24) de la source lumineuse (3), de manière continue avec des angles décroissant par rapport à l'axe optique,
l'angle décroissant correspondant à chaque fois au petit angle entre l'axe optique et la surface de la plaque.

2. Dispositif de polarisation comprenant :
une source lumineuse (3) et un polarisateur (14), notamment pour la polarisation de lumière ultraviolette, pour de grandes ouvertures,
plusieurs plaques (21, 22) transparentes à la lumière, inclinées dans la même direction par rapport à l'axe optique (10, 23) et empilées,
l'angle (17) de la lumière incidente (24) de la source lumineuse (3) étant situé dans la plage de l'angle de Brewster par rapport à la normale (16) à la plaque respective,
les plaques (21, 22) à l'intérieur d'une pile étant disposées en éventail avec des angles légèrement différents et
les plaques ont une section en forme de coin et
les plaque (21, 22) sont disposées avec un angle progressivement décroissant, par rapport à l'axe optique, dans la direction de la lumière incidente (24) de la source lumineuse (3),
l'angle décroissant représentant chaque fois le petit angle compris entre l'axe optique et la surface de la plaque.

3. Dispositif de polarisation comprenant
une source lumineuse (3) et un polarisateur (14) notamment pour polariser la lumière ultraviolette pour de grandes ouvertures,
plusieurs plaques transparentes (21, 22) inclinées par rapport à l'axe optique (10, 23) dans la même direction et empilées,
l'angle (17) de la lumière incidente (24) de la source lumineuse (3) étant compris dans la plage de l'angle de Brewster par rapport à la normale (16) à la plaque respective,
les plaques ayant une section en forme de coin et
les plaques (21, 22) étant disposées dans la direction de la lumière incidente (24) de la source lumineuse (3), avec un angle par rapport à l'axe optique décroissant progressivement,
l'angle décroissant étant chaque fois le plus petit angle compris entre l'axe optique et la surface de la plaque.

4. Dispositif de polarisation selon l'une quelconque des revendications précédentes,
**caractérisé en ce que**
la différence d'angle entre deux plaques voisines (21, 22) est au moins égale à 2°, notamment comprise entre 4° et 6°.

5. Dispositif de polarisation comprenant :
une source lumineuse (3) avec un polarisateur (14) notamment pour polariser de la lumière ultraviolette, pour de grandes ouvertures,
des plaques (27, 28, 29) transparentes, de préférence planes, parallèles, et dont la normale respective à la plaque se situe dans l'angle de Brewster par rapport à la lumière incidente (32, 33) de la source lumineuse, cette lumière arrivant essentiellement parallèlement à l'axe optique,
les plaques (27) et (28, 29) étant inclinées dans des directions différentes par rapport à l'axe optique,
**caractérisé en ce que**
l'une des deux plaques est subdivisée en deux parties (28, 29) et ces deux parties de plaques (28, 29) sont placées avec les autres plaques non divisées (27) suivant une disposition en X.

6. Dispositif de polarisation selon la revendication 5,
**caractérisé en ce que**
les deux parties de plaques (28, 29) sont disposées à partir du plan commun de la plaque, avec un léger décalage, parallèlement par rapport à l'axe optique.

7. Dispositif de polarisation selon la revendication 5,
**caractérisé en ce que**
les deux parties de plaques (28, 29) sont munies d'un biseau (36) au niveau de leur petit côté les plus proches de la plaque non divisée (27).

8. Dispositif de polarisation selon l'une quelconque des revendications précédentes dans lequel
au moins l'une des plaques présente une courbure telle que l'angle d'incidence de la lumière incidente, convergeant par rapport à la plaque, est sensiblement constant quel que soit l'emplacement.

9. Appareil de projection comprenant une source lumineuse pour former une unité réalisant une image (7, 8) et une optique image (9), l'unité générant les images (7) étant réalisée sous la forme d'un écran à cristaux liquides (13) avec un premier polarisateur placé dans le chemin des rayons et derrière celui-ci un second polarisateur (15),
**caractérisé en ce qu'**
au moins le premier polarisateur (14) est réalisé selon l'une des revendications précédentes et au moins une partie importante de l'intensité de la lumière incidente non utilisée pour l'image est évacuée du faisceau par réflexion.

10. Appareil de projection selon la revendication 9 comprenant un dispositif de polarisation selon l'une quelconque des revendications 5 ou 6,
**caractérisé en ce que**
la différence angulaire entre deux plaques voisines (21, 22) du dispositif en forme d'éventail est supérieure à la moitié de l'angle d'acceptance de l'optique image (9).

11. Appareil de projection selon l'une quelconque des revendications 9 ou 10,
**caractérisé en ce que**
le second polarisateur (15) se compose d'un filtre de polarisation sous la forme d'une feuille ou d'un filtre de polarisation selon l'une des revendications 1 à 8.

12. Appareil de projection selon l'une quelconque des revendications 9 à 11,
**caractérisé en ce que**
l'écran à cristaux liquides (13) est incliné par rapport à l'axe d'un angle qui correspond à l'angle de la meilleure transmission, notamment la normale à la surface de l'écran à cristaux liquides, incliné de 3° à 6° par rapport à l'axe optique.

13. Appareil de projection selon l'une quelconque des revendications 9 à 12,
**caractérisé par**
un filtre transparent aux rayons UV dans le faisceau entre la source lumineuse (3) et l'unité formant des images (7, 8).

14. Appareil selon l'une quelconque des revendications 9 à 13,
**caractérisé par**
un élément optique transparent à la lumière ultraviolette entre la source lumineuse (3) et l'unité formant les images (7, 8), cet élément réfléchissant une partie importante de l'intensité lumineuse de la plage spectrale non utilisable.

15. Dispositif pour la fabrication photomécanique d'une surface structurée, notamment pour éclairer des plaques d'impression avec une tête d'éclairage (1), mobile,
**caractérisé en ce que**
la tête d'éclairage (1) est munie d'un appareil de projection selon l'une des revendications 9 à 14.
